# EUROPEAN PATENT APPLICATION

(11) **EP 1 585 324 A1**
(43) Date of publication of application: **12.10.2005**
(21) Application number: 05251954.3
(22) Date of filing: 30.03.2005
(51) Int. Cl.: H04N 5/64

(54) **Liquid crystal television device comprising a recording/reproducing device such as a dvd recorder/player or the like**

(30) Priority: 31.03.2004 JP 2004106295
(71) Applicant: ORION ELECTRIC CO., Ltd., Fukui 915-8555 (JP)
(72) Inventor: Nishida, Kazufumi, Takefu-city Fukui 915-8555 (JP); Miura, Jun, Takefu-city Fukui 915-8555 (JP)
(74) Representative: Paget, Hugh Charles Edward

(57) **Abstract**

To provide a liquid crystal television which is small in size and low in price, by designing the construction of the control circuit boards of a liquid crystal display device including a recording/reproducing device such as a DVD or the like and the layout construction thereof.

The present invention is characterized by installing three main boards comprising:
a television circuit board mounted with an analog control circuit for power supply processing, audio video signal processing, etc.,
a circuit board for a DVD circuit mounted with a DVD driving control circuit and
a liquid crystal circuit board mounted with a liquid crystal digital control circuit on the back of a liquid crystal panel unit in a liquid crystal television device mounted with a recording/reproducing device such as a DVD or the like.

## Description

### BACKGROUND OF THE INVENTION

### Field of the Invention

The present invention relates to a liquid crystal television device mounted with a recording/reproducing device such as a DVD or the like, and relates in particular to a liquid crystal television device having characteristic layout construction comprising the multiple circuit boards of a DVD and the liquid crystal display control unit of a television.

Moreover, the "recording/reproducing device" refers to a device having a recording function or a reproduction function or a device having a recording function and a reproduction function meeting the specification.

### Description of the Related Art

Liquid crystal television devices provided with a recording/reproducing device such as a DVD, etc. in a television set capable of viewing both DVD reproductions and television broadcasts in one set have heretofore been known, as disclosed in Patent documents 1 to 5.

In the general construction of circuit boards of conventional liquid crystal television devices capable of viewing both DVD reproductions and television broadcasts, a large unit arranged in the liquid crystal television device set is mainly provided with a liquid crystal display device, a liquid crystal television circuit board mounted with a liquid crystal digital control circuit, an analog control circuit of other power supply processing, audio video signal processing, etc. and a DVD circuit board mounted with a control circuit for DVD recording/reproducing device and DVD driving.
[Patent document 1]
   Japanese Laid-Open Patent Application 2001-332072
[Patent document 2]
   Japanese Laid-Open Patent Application H11-126034
[Patent document 3]
   Japanese Laid-Open Patent Application H9-182000 GB 2301506
[Patent document 4]
   Japanese Laid-Open Patent Application H8-22016
[Patent document 5]
   Japanese Laid-Open Patent Application H6-230156

Such a liquid crystal television device including a recording/reproducing device such as a DVD or the like enables enjoying both DVD reproduction and television broadcasts in one liquid crystal display set, but a DVD recording/reproducing device and its control circuit board must be provided in addition to the television display device and its control circuit board, and therefore had to become large in size in comparison with the liquid crystal display set of only a liquid crystal television device.

The present invention was made in view of such a point and is directed at providing a liquid crystal television device which has a small set and is inexpensive due to the small size and design of the construction of the control circuit boards of a liquid crystal display device including a recording/ reproducing device such as a DVD or the like and its layout construction.

The present invention was technically based as follows.
(1) It is common to design a liquid crystal digital control circuit in a multilayer circuit board including both surface and rear face while considering performance, etc.
(2) Therefore, if a liquid crystal digital control circuit and an analog control circuit are mounted on the same circuit board (multilayer circuit board), as in the prior art, a larger board is needed, increasing the unit price of the circuit board.
(3) If a liquid crystal digital control circuit and an analog control circuit are mounted on the same circuit board, the device is easily affected by radiation related noise.
(4) In order to overcome the above, the liquid crystal digital control circuit and analog control circuit are separated, the liquid crystal digital control circuit being designed in a multilayer circuit board and the analog control circuit being designed in a one-side circuit board, respectively.

The size of one-side circuit board (analog control circuit board of power supply processing, audio video signal processing, etc.) is usually larger than that of the multilayer circuit board (liquid crystal digital control circuit board), and therefore cannot be received and provided in a common-size display control device.

The present invention is characterized by the fact that three main boards comprising:
a television circuit board mounted with an analog control circuit for at least power supply processing and audio video signal processing;
a DVD circuit board circuit mounted with a DVD driving control circuit; and
a liquid crystal circuit board mounted with a liquid crystal digital control circuit,
are installed on the back of a liquid crystal panel unit in a liquid crystal television device mounted with a recording/reproducing device such as a DVD or the like.

The present invention is preferably characterized by the fact that the television circuit board is a one-side mounting board made of paper, and the circuit board for DVD circuit and the liquid crystal circuit board are multilayer boards.

Furthermore, the present invention is preferably characterized by the fact that a DVD recording/ reproducing device and the television circuit board are arranged in a plane on the back of the liquid crystal panel unit, and the liquid crystal circuit board and the circuit board for DVD circuit are arranged by putting one board on the other to form a two-story deck in another space.

The present invention is further preferably characterized by the fact that the circuit board for the DVD circuit is arranged by placing it on the liquid crystal circuit board, and the DVD recording/reproducing device and the circuit board for DVD circuit are linearly connected with a control signal cable and a pickup signal cable, respectively.

Moreover, the present invention is characterized by the fact that three main boards comprising:
a television circuit board comprising a circuit of power supply processing function, a circuit of audio multiplex processing function, a circuit of audio output processing function, a circuit of audio input switch processing function, a circuit of video switch processing function, a circuit of microcomputer processing function and a memory part, and
a circuit board for a DVD circuit comprising a circuit of audio signal processing function, a circuit of video signal storage function, a circuit of control signal storage function, a circuit of MPEG processing function, a circuit of pickup signal processing function and a circuit of motor control function, and
a liquid crystal circuit board comprising an video signal conversion function circuit consisting of a circuit of analog-digital conversion function, a circuit part of I/P (Interlace/Progressive) conversion function and a circuit of SCALER function are installed on the back of a liquid crystal panel unit in a liquid crystal television device mounted with a recording/ reproducing device such as a DVD or the like.

### SUMMARY OF THE INVENTION

As described above, the present invention enables to overcoming the problems and drawbacks of the prior art because it can arrange and provide circuit boards which effectively use a space in a display control device set of a liquid crystal television capable of viewing both DVD reproduction and television and does not any cause trouble relative to performance.

Namely, (1) noise relating to radiation can be prevented because the digital control circuit and analog control circuit are separated and mounted on independent circuit boards.
(2) The size of the circuit boards can be reduced contributing to the miniaturization and low price of the liquid crystal control device because the circuit board mounting the digital control circuit is made into a multilayer circuit board, including both the surface and rear face.
(3) Although the present invention is constructed by three circuit boards, the circuit board construction can be miniaturized overall by designing functional circuits mounted in each circuit board, and can receive and provide the circuits in a space of at least same extent as the liquid crystal television device of the prior art constructed by two circuit boards.
(4) When a single model of liquid crystal television mounting no DVD device is produced by not installing a DVD circuit board and DVD recording/ reproducing device, the present invention can provide a thinner liquid crystal television single device unit because the DVD driving circuit board is placed above the liquid crystal circuit board and arranged side by side with the DVD recording/ reproducing device.

### BRIEF DESCRIPTION OF THE DRAWINGS

Fig. 1 Schematic diagram showing a state of arranging boards of a liquid crystal television device set of the present invention.
Fig. 2 Block diagram showing arrangement positions of boards in the present invention.
Fig. 3 Layout diagram of function circuits of a television circuit board.
Fig. 4 Layout diagram of function circuits of a DVD circuit board.
Fig. 5 Layout diagram of functional circuits of a circuit board for liquid crystal.
Fig. 6 Layout diagram showing a relation of installation positions of a DVD recording/ reproducing device and a DVD circuit board **12.**

### DETAILED DESCRIPTION OF THE PREFERRED EMBODIMENTS

An embodiment of the present invention is described hereafter, with reference to the drawings.

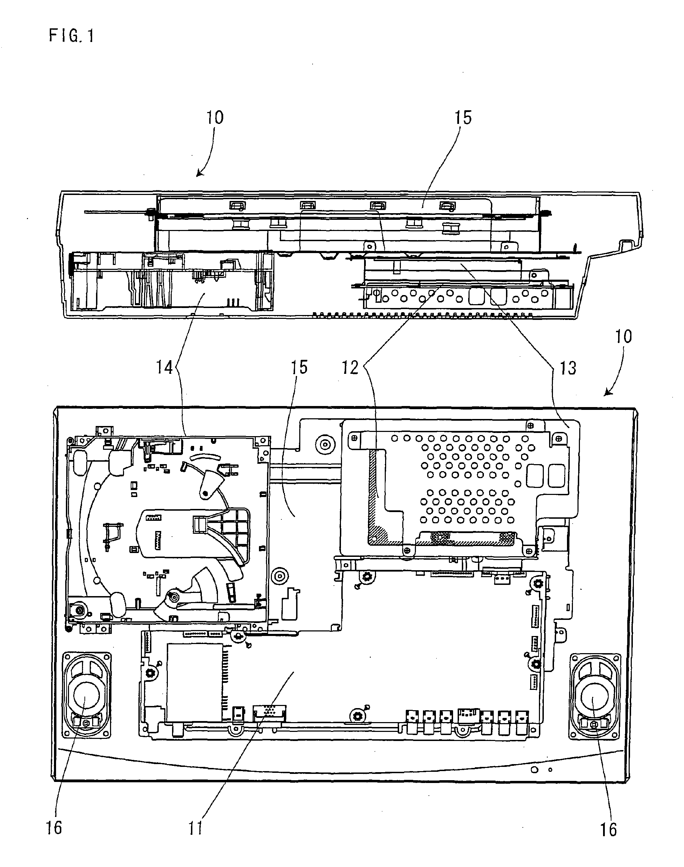

Fig. 1 is a schematic diagram for illustrating an embodiment of the present invention and showing the state of arranging the circuit boards of the liquid crystal display of a liquid crystal television device which enables viewing both DVD reproduction and television broadcasts.

In Fig. 1, **10** indicates an entire liquid crystal display set of a liquid crystal television device. No. **11** is a television circuit board mounted with an analog control circuit for power supply processing/audio video signal processing, etc. and is prepared with a paper one-side board as kind of board at a low cost. No. **12** is a circuit board for DVD circuit mounted with a DVD driving control circuit and is made to a multilayer structure. No. **13** is a liquid crystal circuit board mounted with a liquid crystal digital control circuit and is also made to be multilayer structure. **No**. **14** is a DVD recording/ reproducing device, and **15** is a liquid crystal panel unit. **Nos. 16, 16** are left and right speakers.

According to the embodiment of the present invention, first, a control circuit board for a liquid crystal television in a liquid crystal television mounted with a recording/ reproducing device such as a DVD or the like is designed by separating it into a digital circuit board and an analog circuit board, and designed with consideration to cost and performance, wherein the analog control circuit for power supply/audio-circuit, etc. is mounted and arranged on the one-side television circuit board **11,** and the liquid crystal digital control circuit is mounted and arranged on the multilayer circuit board and provided in a display control device set, respectively.

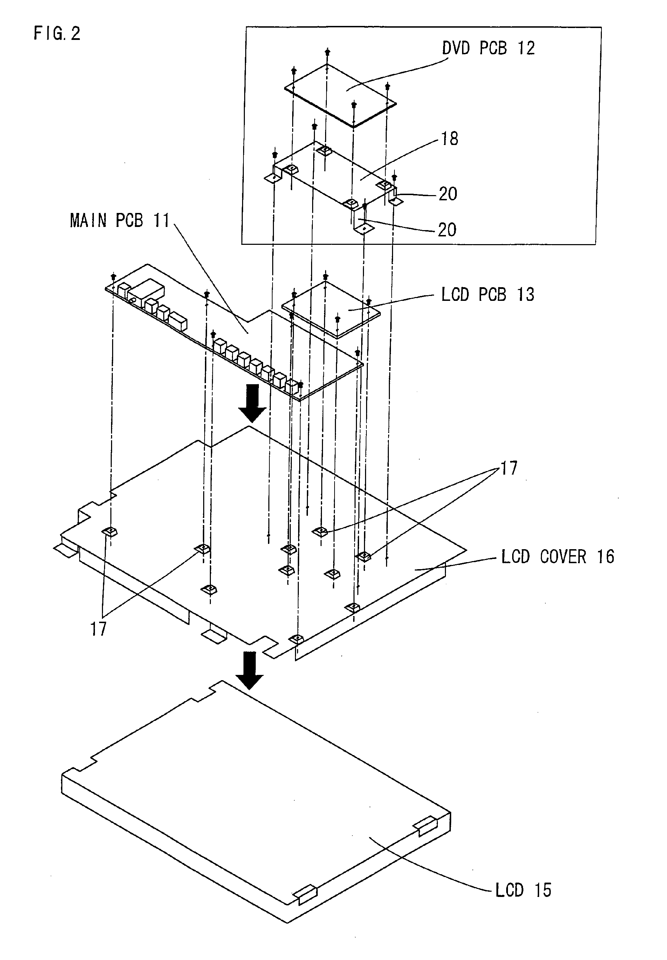

Layout construction of the boards in the present invention is clearly shown in Fig. 2. The boards are installed in a liquid crystal panel unit cover **16** (expressed as LCD COVER in the diagram) mounted to the rear face of the liquid crystal panel unit **15** (expressed as LCD in the diagram). Multiple embossed parts **17, 17, 17...** for board installation are formed on the cover **16,** and screws are cut into the embossed parts. First, the television circuit board **11** (expressed as MAIN PCB in the diagram) mounted with the analog control circuit for power supply/audio video signal processing, etc. and the liquid crystal circuit board **13** (expressed as LCD PCB in the diagram) mounted with the liquid crystal digital control circuit are installed on the cover **16.** Next, the circuit board for DVD circuit **12** mounted with a DVD driving control circuit is installed on embossed parts **19, 19** of a board cover **18** covering the liquid crystal circuit board **13.** The board cover **18** also has both the function of covering the liquid crystal circuit board **13** and the function of installing the circuit board for DVD circuit **12** and is provided with legs **20, 20** bent at four corners, the legs being bent into an L shape and mounted to the liquid crystal panel unit cover **16** with vises.

The positional relationships for arranging these boards are expressed by the chain lines shown in Fig. 2. Namely, according to the embodiment of the present invention, three main circuit boards: the television circuit board **11** mounted with the analog control circuit for power supply/audio-circuit, etc., the liquid crystal circuit board **13** mounted with the liquid crystal digital control circuit and the DVD circuit board **12** mounted with the DVD driving control circuit are provided on the liquid crystal panel unit **15** in the liquid crystal display set of the liquid crystal television device.

The layout of functional circuits of the circuit boards in the liquid crystal display set of the liquid crystal television device are described next. First, the television circuit board **11** has been designed with a paper one-side circuit board, but a "circuit having an analog control function of power supply/audio-circuit, etc.", except for a "circuit of a liquid crystal digital control function" which is mounted in the multilayer circuit board designed with the multilayer circuit board of the prior art, is mounted, therefore the size of the circuit board is not larger than the size of the circuit board for the liquid crystal television in the prior art, and the circuit arrangement of the television circuit board **11** mounted with the analog control circuit such as power supply/ audio-circuit, etc. can be arranged in a space nearly the same as the arrangement in liquid crystal television device of the prior art. Namely, the television circuit board **11** is received in a size capable of loading it onto a rear face of a liquid crystal panel unit of conventional size.

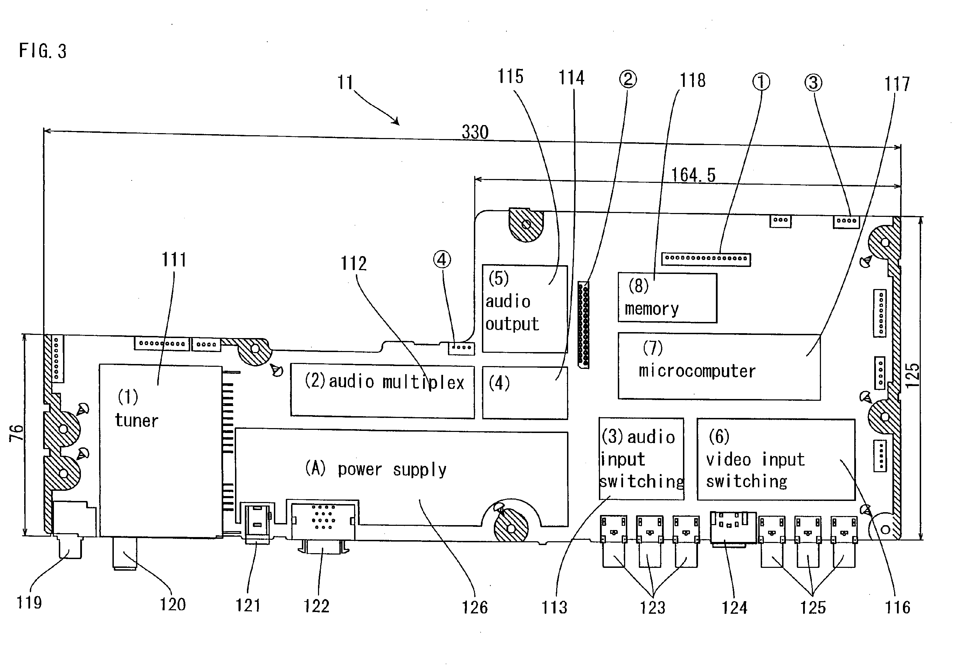

A layout diagram of the specific functional circuits of the one-side television circuit board 11 mounted with the analog control circuit such as power supply/audio-circuit, etc. is shown in Fig. 3. This analog circuit board 11 is prepared inexpensively with a paper one-side board, input/output terminals such as a digital audio output terminal **119,** an antenna input terminal **120,** a DC input terminal **121,** a digital RGB input terminal **122,** an AV input terminal **123,** an S input terminal **124** and a component input terminal **125** are arranged at the end face of board. Then, a tuner **111** (expressed as (**1**) in the diagram) is arranged by laying it down in the vicinity of the antenna input terminal **120.** A circuit of power supply processing function **126** (expressed as **(14)** in the diagram) of a transformer or many condensers (non-illustrated) is arranged near the end face of the board in the vicinity of the DC input terminal 121 and digital RGB input terminal **122.** A circuit of the audio multiplex processing function **112** (expressed as **(2)** in the diagram), a circuit of audio output **114** (expressed as **(4)** in the diagram) and a circuit of the audio output processing function **115** (expressed as **(5)** in the diagram) are arranged at the rear of the circuit of the power supply processing function **126.** A circuit of audio input switch processing function **113** (expressed as **(3)** in the diagram) and a circuit of the video switch processing function **116** (expressed as **(6)** in the diagram) are arranged in the vicinity of the AV input terminal **123,** S input terminal **124** and component input terminal **125.** A circuit of the microcomputer processing function **117** (expressed as **(7)** in the diagram) and a memory part **118** (expressed as **(8)** in the diagram) are arranged at the rear thereof.

Although the actual external dimensions of the board used in a 14-inch liquid crystal television are entered for reference, they are not meant to limit the present invention. Hatching areas in Fig. 3 (wrong figure number Fig. 2 in original document) show areas without mounted parts, the parts depicting screws are screwing signs and are used for installing the boards (same in other parts). (1), (2), (3) and (4) are attached to connector parts in the board, (1) is for a DVD signal, (2) is for a liquid crystal panel signal, (3) is for the power supply of a digital circuit board, and (4) is used for a back light power supply.

As described above, the television circuit board **11** can be arranged in a space nearly the same as the layout in a prior art set, even if it is taken as a one-side board made of paper, because the television circuit board **11** is used as the board construction for analog processing circuit. Therefore the liquid crystal circuit board **13** mounted with the liquid crystal digital control circuit and the DVD circuit board **12** mounted with the DVD driving control circuit can be arranged at the back of the liquid crystal panel unit **15** except for installing the television circuit board **11.** At this time, the DVD circuit board **12** and the liquid crystal circuit board **13** are arranged by putting one board on the other to form a two-story deck. Hence, the size of the liquid crystal television device is not larger than the size of a prior art liquid crystal television.

Accordingly, the DVD circuit board **12** and the liquid crystal circuit board **13** are arranged by putting one board on the other so that they become lower than the height of DVD recording/ reproducing device **14** in a space of the back of liquid crystal panel except for the position for installing the television circuit board **11.** Moreover, if the DVD driving circuit board **12** is arranged by placing it above the liquid crystal circuit board **13,** in a case of liquid crystal television single model, a thinner liquid crystal television single device set can be obtained by constructing the device without installing the DVD circuit board **12** and the DVD recording/ reproducing device **14.**

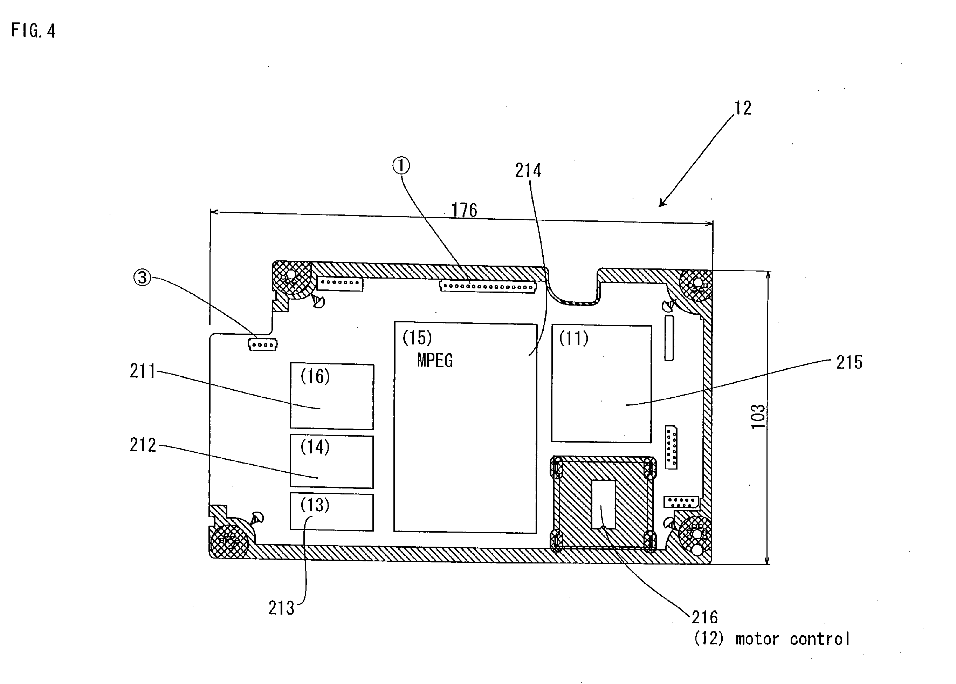

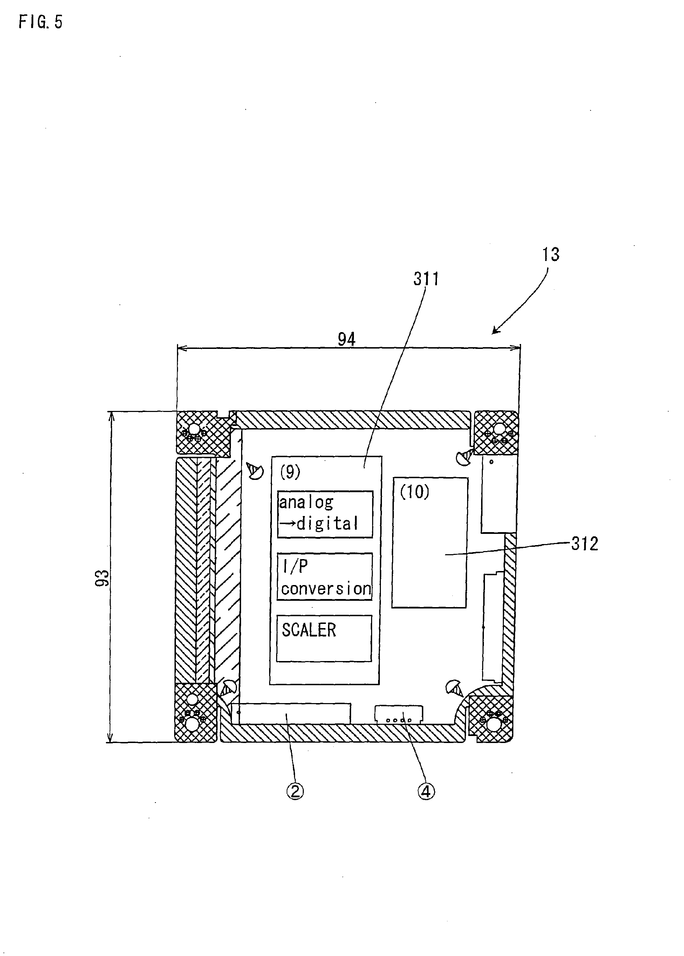

Here, layout diagrams of specific functional circuits of the DVD circuit board **12** and the liquid crystal circuit board **13** are shown in Fig. 4 and Fig. 5. The DVD circuit board **12** is prepared with a multilayer board, an audio signal processing function circuit **211** (expressed as (16) in the diagram), an video signal storage function circuit **212** (expressed as (14) in the diagram) and a control signal storage function circuit 213 (expressed as (13) in the diagram) arranged on the board. An MPEG processing function circuit **214** (expressed as (15) in the diagram) is arranged in the central part of the board, a pickup signal processing function circuit **215** (expressed as (11) in the diagram) and a motor control function circuit **216** (expressed as (12) in the diagram) are further arranged on the board. The liquid crystal circuit board **13** is prepared with a multilayer board, an video signal conversion function circuit **311** (expressed as (9) in the diagram) comprising an analog-digital conversion function circuit, an I/P conversion function circuit and a SCALER function circuit and an video signal conversion auxiliary function circuit **312** (expressed as (10) in the diagram) are arranged on the board.

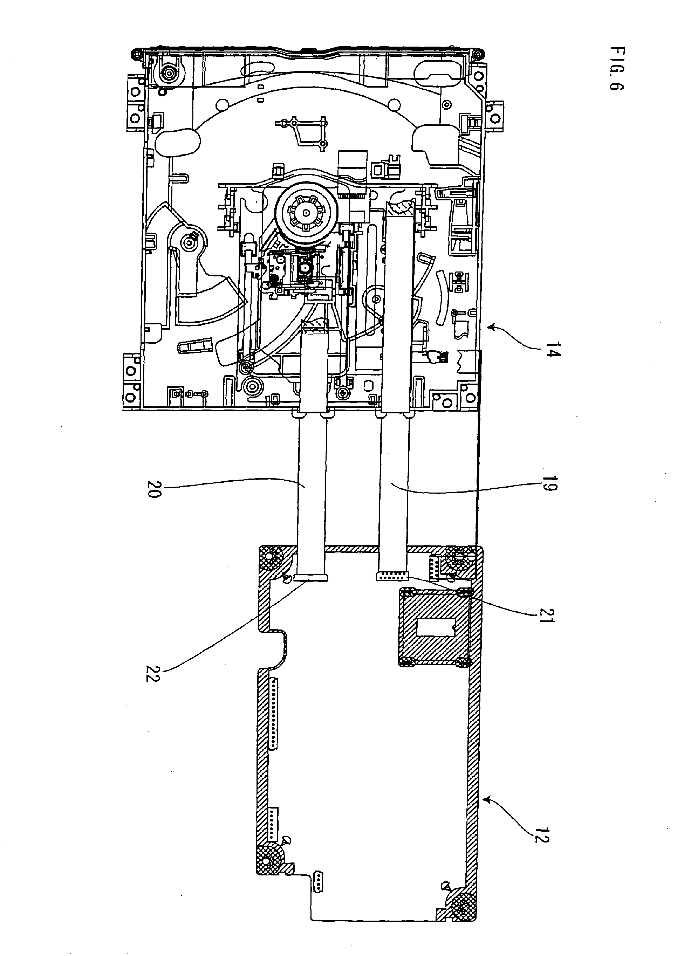

The relation of installation positions of the DVD recording/reproducing device **14** and the DVD circuit board **12** is shown in Fig. 6. The DVD recording/ reproducing device **14** and the DVD circuit board **12** are connected by a control signal cable **19** and a pickup signal cable **20** for exchanging signals for the motor drive of the DVD recording/ reproducing device and for exchanging audio video information signals, etc. for information recording/production. At the present time, a control signal cable connector **21** and a pickup signal cable connector **22** on the DVD circuit board **12** are arranged to match the control signal fetch position and the pickup signal fetch position on the DVD recording/ reproducing device **14** side, linearly arranging both of the cables **19, 20.**

The present invention has the construction as described above and uses the following working effects.
(1) The present invention can prevent radiation related noise by separating the analog control circuit and the digital control circuit and mounting the circuits on independent circuit boards.
(2) The present invention reduces the arrangement space by arranging a multilayer circuit board mounted with the digital control circuit and a circuit board mounted with DVD driving control circuit and putting one board on the other.
(3) The present invention provides a thinner liquid crystal television single model device by producing a liquid crystal television single model without installing a DVD driving circuit board because a DVD driving circuit board mounted with a DVD driving control circuit is arranged by placing it above a liquid crystal circuit board mounted with a liquid crystal digital control circuit.

## Claims

1. A liquid crystal television device mounted with a recording/reproducing device, such as a DVD or the like, **characterized by** the fact that three main boards comprising:
a television circuit board mounted with analog control circuit for power supply processing/audio video signal processing, etc.; a circuit board for DVD circuit mounted with a DVD driving control circuit; and
a liquid crystal circuit board mounted with a liquid crystal digital control circuit,
are installed on the back of a liquid crystal panel unit in a liquid crystal television device mounted with a recording/reproducing device such as a DVD or the like.

2. The liquid crystal television device mounted with a recording/reproducing device such as a DVD or the like according to Claim 1, **characterized by** the fact that the television circuit board is a one-side mounting board made of paper, and the circuit board for the DVD circuit and the liquid crystal circuit board are multilayer boards.

3. The liquid crystal television device mounted with a recording/ reproducing device such as a DVD or the like according to Claim 1 or Claim 2, **characterized by** the fact that the DVD recording/reproducing device and the television circuit board are arranged in a plane, and the liquid crystal circuit board and the circuit board for DVD circuit are arranged by putting one board on the other to become a two-story deck in another space.

4. The liquid crystal television device mounted with a recording/reproducing device such as a DVD or the like according to Claim 3, **characterized by** the fact that the circuit board for DVD circuit is arranged by placing it on the liquid crystal circuit board, and the DVD recording/ reproducing device and the circuit board for DVD circuit are linearly connected with a control signal cable and a pickup signal cable.

5. A liquid crystal television device mounted with a recording/reproducing device such as a DVD or the like, **characterized by** the fact that three main boards comprising:
a television circuit board comprising a circuit of power supply processing function, a circuit of an audio multiplex processing function, a circuit of an audio output processing function, a circuit of an audio input switch processing function, a circuit of an video switch processing function, a circuit of a microcomputer processing function and a memory component;
a circuit board for a DVD circuit comprising a circuit of an audio signal processing function, a circuit of an video signal storage function, a circuit of a control signal storage function, a circuit of an MPEG processing function, a circuit of a pickup signal processing function, a circuit of a motor control function; and a liquid crystal circuit board comprising an video signal conversion function circuit consisting of a circuit of analog-digital conversion function, a circuit of an I/P conversion function and a circuit of a SCALER function,
are installed on the back of a liquid crystal panel unit in a liquid crystal television device mounted with a recording/reproducing device such as a DVD or the like.
